# FASCICULE DE BREVET EUROPEEN

(11) **EP 1 139 430 B1**
(45) Date de publication et mention de la délivrance du brevet: **08.10.2008**
(21) Numéro de dépôt: 01410032.5
(22) Date de dépôt: 29.03.2001
(51) Int. Cl.: H01L 29/10, H01L 21/336, H01L 21/762, H01L 21/8234

(54) **Transistor MOS dans un circuit intégré et procédé de formation de zone active**
MOS-Transistor in einem integrierten Schaltkreis und Verfahren zur Herstellung der aktiven Zone
MOS transistor in integrated circuit and method of manufacturing the active zone

(30) Priorité: 31.03.2000 FR 0004174
(43) Date de publication de la demande: 04.10.2001
(73) Titulaire: STMicroelectronics S.A., 92120 Montrouge (FR); NXP B.V., 5656 AG Eindhoven (NL)
(72) Inventeur: De Coster, Walter, 38330 Saint Nazaire les Eymes (FR); Lunenborg, Meindert, 38920 Crolles (FR); Inard, Alain, 38330 Saint Nazaire les Eymes (FR); Guelen, Jos, 6581 GB Malden (NL)
(74) Mandataire: Thibon, Laurent

(56) Documents cités:
- DE-A- 2 641 334
- GB-A- 1 075 085
- GB-A- 2 030 769
- US-A- 5 132 755
- US-A- 5 357 137
- US-A- 5 424 571
- TANG X ET AL: "INTRINSIC MOSFET PARAMETER FLUCTUATIONS DUE TO RANDOM DOPANT PLACEMENT" IEEE TRANSACTIONS ON VERY LARGE SCALE INTEGRATION (VLSI) SYSTEMS,US,IEEE INC. NEW YORK, vol. 5, no. 4, 1 décembre 1997 (1997-12-01), pages 369-376, XP000723679 ISSN: 1063-8210

## Description

La présente invention concerne, de façon générale, les circuits intégrés sur substrat semiconducteur comprenant au moins un composant formé dans une zone active et plus particulièrement la formation de zones actives entourées de zones isolantes. Ces zones isolantes sont obtenues à partir de tranchées remplies d'un matériau isolant et chaque zone active est destinée à recevoir une structure conductrice isolée de celle-ci, par exemple une grille de commande d'un dispositif de type transistor. Le dispositif peut être un transistor MOS formé par toute technologie connue (MOS, CMOS, BiCMOS).

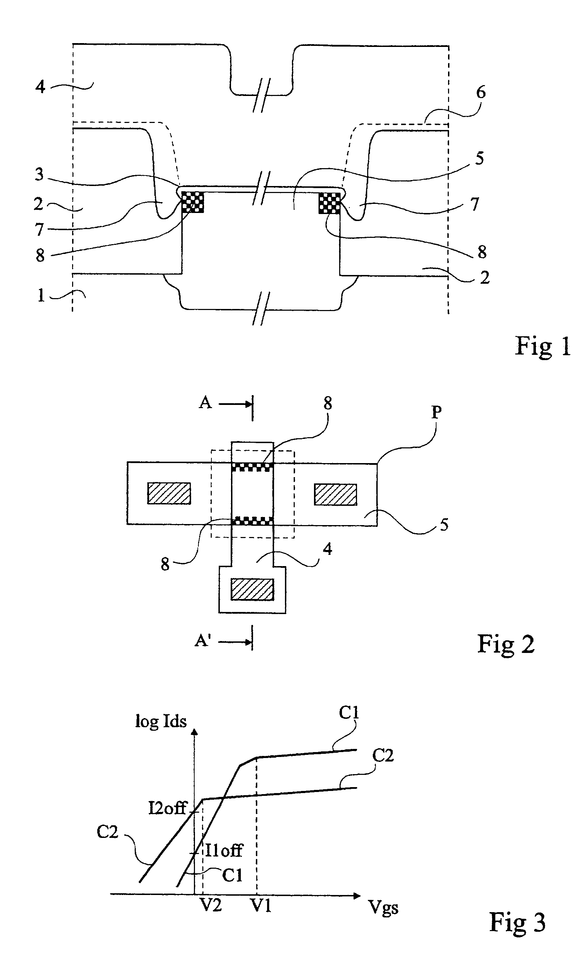

La figure 1 illustre partiellement et schématiquement, en coupe transversale, un substrat semiconducteur 1 sur lequel est formée une ligne conductrice isolée. On considère ci-après à titre d'exemple non-limitatif que cette ligne est une électrode de grille d'un transistor MOS de type latéral.

En figure 1, le substrat 1 comporte une zone active 5 délimitée par une zone isolante 2. La zone isolante 2 a été formée en creusant des tranchées dans le substrat, puis en les remplissant d'un matériau isolant, typiquement de l'oxyde de silicium (SiO₂). Le remplissage est effectué de sorte que le matériau isolant déborde, comme l'indique le trait en pointillés 6, par rapport au niveau défini par le substrat, d'où il résulte que la zone isolante 2 présente un sommet ayant une surface sensiblement plane à un niveau supérieur à la surface de la zone active 5 ainsi définie, ce sommet se terminant par un rebord sensiblement vertical menant à la zone active 5. Une telle structure de zone isolante 2 peut être classiquement obtenue de diverses manières, comme cela va être exposé ci-après.

La zone isolante 2 présente, au contact de la zone active 5, une zone de fragilisation qui, suite à des surgravures lors d'étapes ultérieures d'élimination de divers matériaux isolants sacrificiels, va provoquer une dépression 7 en périphérie de la zone active 5.

Au niveau d'une zone de grille, une couche mince 3 d'isolant recouvre la surface supérieure de la zone active 5 ainsi que sa partie périphérique découverte par la dépression 7. La couche 3 est recouverte d'une couche 4 d'un matériau conducteur, typiquement du silicium polycristallin. Le matériau conducteur 4 passe sur la zone isolante 2 et sur la zone active 5, et remplit la dépression 7. Le remplissage de la dépression 7 par le matériau de grille a des effets gênants. En effet, à cause de la courbure présentée sur le bord de la zone active 5 par le matériau de grille du fait de cette dépression, la distribution du champ électrique dans la zone de canal située au bord de la zone isolante 2 est perturbée, ce qui détériore, comme cela va être vu ci-après, les performances du transistor.

La figure 2 illustre en vue de dessus un transistor MOS de type latéral. Dans ce cas, la figure 1 correspond à une vue partielle en coupe selon la ligne A-A', limitée par une zone définie par les traits en pointillés. La zone active 5 comporte une zone de canal, située sous une grille de commande 4 et, de part et d'autre de la grille, des régions de source et de drain. Les points de prise de contact de grille, de drain et de source sont mis en évidence par des régions hachurées, dont la localisation est indifférente à l'exposé de la présente invention.

La dépression 7 présentée par la zone isolante 2 se trouve sur toute la périphérie P de la zone active 5. Les portions de la périphérie P sous-jacentes à la grille sont mises en évidence par des damiers 8 et on peut considérer que le transistor MOS de la figure 2 est formé de deux transistors : un transistor central à performances normales, ayant sa grille plane et parallèle à la surface du substrat 1, et, de part et d'autre du transistor central, un transistor parasite à performances détériorées situé le long de la zone isolante 2, présentant une grille non plane s'étendant sur la dépression 7.

La figure 3 représente le courant drain-source Ids, en coordonnées logarithmiques en fonction de la tension grille-source Vgs. La courbe C1 correspond au transistor central et présente une tension de seuil normale V1 et un courant de fuite Iloff (courant Ids pour Vgs=0) normal. La courbe C2 correspond au transistor parasite et présente une tension de seuil V2 diminuée et un courant de fuite I2off augmenté. Comme le transistor MOS résultant présente une caractéristique correspondant à la somme des deux courbes C1 et C2, sa tension de seuil va être également abaissée et surtout son courant de fuite Ioff augmenté. Cela provoque des fuites, très gênantes par exemple dans des applications où le transistor considéré fait partie d'une puce alimentée par une pile, comme dans les téléphones portables, la pile étant susceptible alors de se décharger plus rapidement.

Par ailleurs, on notera que les effets néfastes du transistor parasite sont d'autant plus importants que la zone active 5 est étroite. Vu la tendance constante de l'industrie des semiconducteurs à la réduction des dimensions des transistors, l'effet néfaste du transistor parasite ne peut que s'accentuer et, à la limite, le transistor central peut ne plus exister si la largeur de la grille devient trop faible, le transistor résultant n'étant plus formé que par le transistor parasite.

C'est pourquoi un objet de la présente invention est de proposer un transistor MOS qui évite les inconvénients de l'art antérieur.

Un autre objet de la présente invention est de proposer un transistor MOS qui présente un seuil de tension non détérioré.

Un autre objet de la présente invention est de proposer un procédé de formation de zone active de canal dans un substrat semiconducteur permettant d'obtenir une telle structure.

Pour atteindre ces objets ainsi que d'autres, la présente invention prévoit un procédé de formation d'une zone active entourée d'une zone isolante dans un substrat semiconducteur, comprenant les étapes suivantes :
a) former, dans le substrat, une tranchée entourant une zone active ;
b) remplir la tranchée d'un matériau isolant de façon à former un rebord dépassant de la surface du substrat à la périphérie de la zone active ;
c) former un espaceur à la périphérie dudit rebord ; et
d) effectuer une implantation d'un dopant, d'où il résulte que l'implantation dans la zone située sous l'espaceur est moins profonde que dans le reste de la zone active.

Selon un mode de réalisation de la présente invention, l'espaceur présente un rebord sensiblement vertical ou a une forme en cloche, dont l'épaisseur s'amenuise en s'éloignant dudit rebord.

Selon un mode de réalisation de la présente invention, l'étape d'implantation est suivie d'une étape d'élimination de l'espaceur.

Selon un mode de réalisation de la présente invention, l'étape d'élimination de l'espaceur est précédée ou suivie d'une étape d'implantation d'une autre zone active avec un dopant d'un autre type de conductivité que celle du dopant utilisé à l'étape d).

Selon un mode de réalisation de la présente invention, entre l'étape de remplissage de la tranchée et l'étape c) de formation d'un espaceur, est prévue une étape consistant à former, à la surface de la zone active, un revêtement de protection.

Selon un mode de réalisation de la présente invention, le revêtement de protection résulte de la croissance thermique d'une couche mince d'oxyde de silicium à la surface du substrat.

Selon un mode de réalisation de la présente invention, l'espaceur est en nitrure de silicium.

Selon un mode de réalisation de la présente invention, l'espaceur est en silicium polycristallin.

La présente invention prévoit également un transistor MOS comportant une zone de canal dopée adjacente à une zone isolante, les dopants présents dans la partie de la zone de canal en contact avec la zone isolante étant plus proches de la surface que les dopants présents dans le reste de la zone de canal.

La présente invention vise également un circuit intégré incluant un tel transistor et un terminal incluant un tel circuit intégré.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 illustre en vue en coupe partielle et schématique une zone active réalisée selon l'état de la technique ;
la figure 2 illustre en vue de dessus un transistor MOS latéral ;
la figure 3 illustre la caractéristique du courant drain-source en fonction de la tension grille-source du transistor de la figure 2 ; et
les figures 4A, 4B, 4B', 4C et 4D illustrent en vue en coupe partielle et schématique un mode de mise en oeuvre de la présente invention.

Par souci de clarté, les mêmes éléments ont été désignés par les mêmes références aux différentes figures et, de plus, comme cela est habituel dans la représentation des circuits intégrés, les figures 1, 2, 4A, 4B, 4B', 4C et 4D ne sont pas tracées à l'échelle.

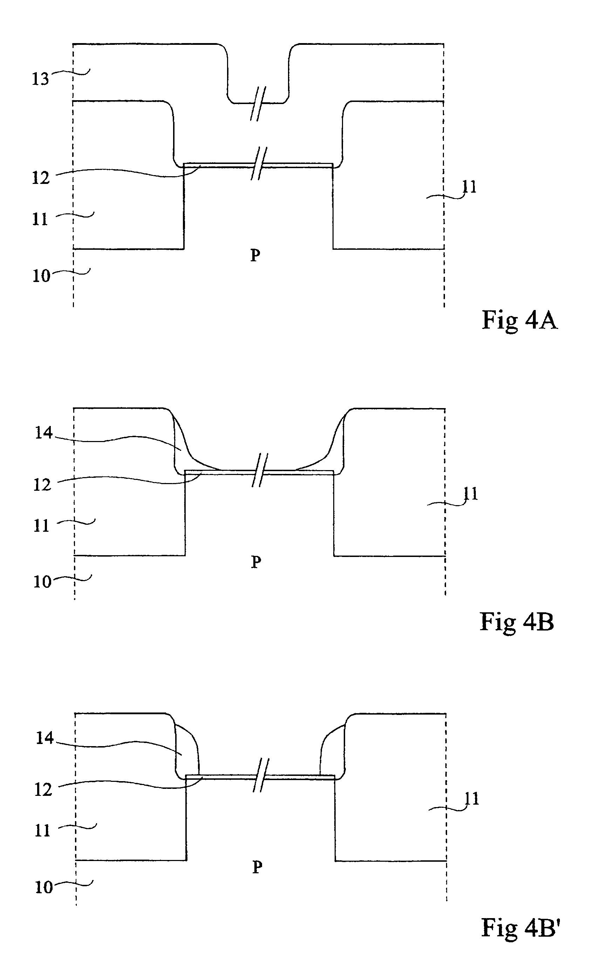

Le procédé selon l'invention commence par la définition d'une zone active dans le substrat 10, par exemple en silicium monocristallin, par une zone isolante 11 (figure 4A).

La zone 11 est formée en creusant dans le substrat 10 des tranchées puis en les remplissant d'un matériau isolant. La zone 11 peut être obtenue par tout procédé classique connu. Il s'agira, par exemple, de la séquence des étapes suivantes : dépôt d'un masque, par exemple en nitrure de silicium (Si₃N₄), ayant typiquement une épaisseur de l'ordre de quelques dizaines de nanomètres, gravure de ce masque de façon à ne le laisser subsister qu'à l'emplacement de la zone active, creusement de tranchées à l'emplacement de la zone isolante, remplissage des tranchées par un matériau isolant, planarisation en s'alignant sur le niveau des parties restantes du masque, puis enlèvement du masque restant.

Dans tous les cas, la zone isolante est réalisée de sorte que le matériau isolant déborde verticalement des tranchées, d'où il résulte que sa surface supérieure se trouve à un niveau supérieur à celui de la zone active. La zone 11 présente donc un rebord dépassant de la surface du substrat 10 à la périphérie de la zone active.

On met ensuite en oeuvre diverses étapes de nettoyage de l'état de la technique, puis on forme une couche sacrificielle 12 de protection de la zone active. Cette couche 12 est par exemple un oxyde thermique amené à croître sur une épaisseur typiquement comprise entre 5 et 15 nm, par exemple de 10 nm.

On dépose ensuite sur l'ensemble de la structure une couche 13 d'un matériau gravable sélectivement par rapport au matériau isolant de la zone isolante 11 et par rapport à la couche sacrificielle 12. La couche 13, par exemple isolante, de préférence en nitrure de silicium (Si₃N₄), a une épaisseur choisie de la façon exposée ci-après. On notera que, suite à son dépôt, la couche 13 présente une sur-épaisseur au niveau du rebord présenté par la zone isolante 11 à la périphérie de la zone active.

Aux étapes suivantes, illustrées en figures 4B et 4B', la couche 13 est gravée de façon à éliminer celle-ci de la surface supérieure des zones 11. Lors de cette gravure, pendant laquelle les matériaux isolants de la zone 11 et de la couche sacrificielle 12 servent d'arrêt de gravure, on laisse en place un espaceur périphérique 14, du fait de la sur-épaisseur de la couche 13 au niveau du rebord entre la surface supérieure de la zone 11 et la zone active.

Selon un mode de réalisation illustré en figure 4B, la gravure de la couche 13 est effectuée de sorte que l'espaceur 14 s'amenuise depuis le rebord de la zone 11 à la périphérie de la zone active vers la partie centrale de cette dernière. Alors, la partie de l'espaceur 14 distale du rebord de la zone 11, au lieu de présenter une paroi sensiblement verticale, présente une forme en "cloche". L'homme de l'art saura mettre en oeuvre des procédés de gravure propres à moduler l'amenuisement de l'épaisseur de la partie inférieure de l'espaceur 14. L'homme de l'art saura également choisir les conditions de gravure et l'épaisseur de la couche isolante épaisse 13 de façon à obtenir un espaceur 14 de largeur voulue. On notera que l'espaceur 14 formé peut également présenter une paroi sensiblement verticale, comme cela est illustré en figure 4B'.

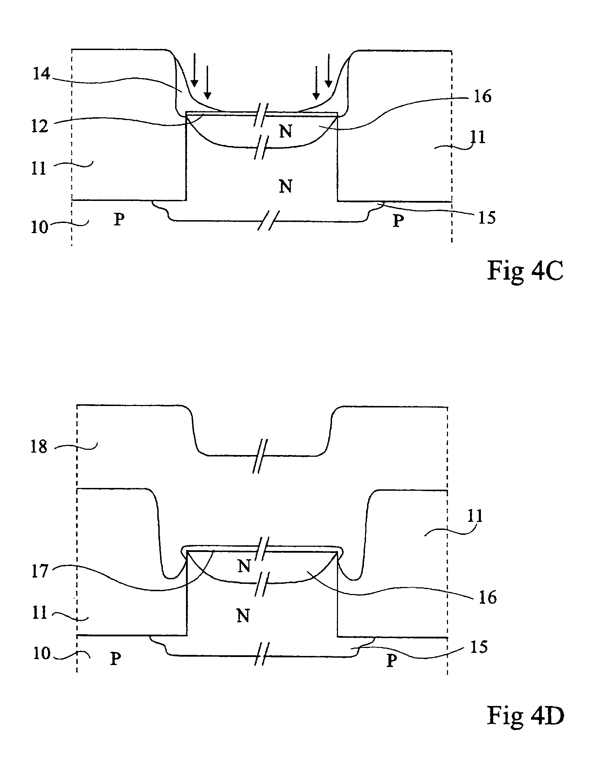

Aux étapes suivantes, illustrées à la figure 4C, on implante la zone active. Dans l'exemple illustré, de formation d'un transistor MOS à canal N, le substrat est de type P et la zone active représentée comporte un caisson de type N. L'implantation de la zone active s'effectue tandis que l'espaceur 14 est en place à la périphérie de la zone active, comme l'illustrent les flèches verticales descendantes, d'où il résulte que les dopants implantés sont ralentis et pénètrent moins profondément dans le substrat 10 à la périphérie, dans la zone recouverte de l'espaceur. Selon des techniques connues, on effectue au moins deux implantations successives de dopants de même nature : une première implantation à haute énergie destinée à former un caisson 15 de type N profond et faiblement dopé, atteignant le substrat 10 en deçà de la zone 11, et au moins une implantation à plus faible énergie destinée à ajuster plus spécifiquement le dopage de la zone active. Le profil 16 résultant de cette deuxième implantation est modifié en périphérie du fait de la présence de l'espaceur 14. Cette zone 16 correspond à la zone de canal effective.

On notera que l'espaceur 14 peut être maintenu en place lors de la formation, dans une autre zone active, de caissons de type différent, par exemple P. Selon un autre mode de réalisation, l'espaceur 14 n'est maintenu en place que pendant la réalisation des caissons de type N dans le substrat de type P.

Aux étapes suivantes, illustrées à la figure 4D, le procédé se poursuit avec l'élimination de l'espaceur 14. Ensuite, la séquence des étapes suivantes est classique.

Ainsi, après des opérations de nettoyage qui provoquent classiquement la formation d'une dépression de la zone 11 à la périphérie de la zone active, on amène à croître un isolant de grille 17. Enfin, on dépose et on grave une couche épaisse 18 d'un matériau conducteur, par exemple du silicium polycristallin, de façon à former la grille de la structure. La couche 18 remplit la dépression de la zone 11.

Grâce à la modification du profil de la région implantée 16, les effets du transistor parasite sur le fonctionnement du transistor résultant sont considérablement réduits.

En effet, du fait que les bords de la zone active présentent une concentration de dopants plus près de la surface, la tension de seuil du transistor parasite se trouve relevée et cela compense la baisse provoquée par le fait que le matériau de grille remplit la dépression périphérique de la zone active. Ainsi, le transistor MOS résultant ne présente pas d'abaissement de sa tension de seuil et son courant de fuite Ioff n'augmente pas. De façon générale, les caractéristiques du transistor MOS formé ne sont pas dégradées et correspondent sensiblement à celles du transistor central.

Par ailleurs, l'influence néfaste du transistor parasite périphérique étant considérablement réduite, les dimensions de la zone active peuvent avantageusement être diminuées.

Un autre avantage de la présente invention est de permettre, après le dopage de la zone active, un "rabotage" du sommet de la zone isolante, qui peut même présenter une surface légèrement en dessous de la surface du substrat. Au contraire de l'art antérieur, l'accentuation de la dépression de la zone isolante 11 périphérique à la zone active provoquée par un tel rabotage n'altère pas les caractéristiques du transistor global du fait du profil de dopage modifié. Cela permet une meilleure planarisation, utile dans les étapes ultérieures de la fabrication du circuit intégré.

Bien entendu, la présente invention est susceptible de diverses variantes et modifications qui apparaîtront à l'homme de l'art. En particulier, on a supposé précédemment que la couche 13 est en un matériau isolant, de préférence du nitrure de silicium. On pourra choisir un autre matériau, isolant ou non, pour autant que l'on respecte les conditions de gravure sélective exposées précédemment. Il pourra par exemple s'agir de silicium polycristallin ou amorphe.

De plus, on a décrit et illustré précédemment les principes de l'invention appliqués à la formation d'un transistor MOS. L'homme de l'art notera toutefois que, de façon générale, la présente invention s'applique à la fabrication de tout type de dispositif dès que celui-ci comporte une zone active définie par des tranchées d'isolement.

L'homme de l'art saura également adapter les matériaux décrits à une filière de fabrication spécifique et sélectionner l'ordre de réalisation des diverses étapes de dopage, ainsi que les niveaux de dopage des diverses couches semiconductrices en fonction des performances recherchées.

## Revendications

1. Procédé de formation d'une zone active de canal entourée d'une zone isolante (11) dans un substrat semiconducteur (10), comprenant les étapes suivantes :
a) former, dans le substrat, une tranchée entourant une zone active ;
b) remplir la tranchée d'un matériau isolant (11) de façon à former un rebord dépassant de la surface du substrat à la périphérie de la zone active ;
c) former un espaceur (14) à la périphérie dudit rebord ; et
d) effectuer une implantation d'un dopant, d'où il résulte que l'implantation dans la zone située sous l'espaceur est moins profonde que dans le reste de la zone active.

2. Procédé selon la revendication 1, dans lequel l'espaceur (14) présente un rebord sensiblement vertical ou a une forme en cloche, dont l'épaisseur s'amenuise en s'éloignant dudit rebord.

3. Procédé selon la revendication 1, dans lequel l'étape d'implantation est suivie d'une étape d'élimination de l'espaceur (14).

4. Procédé selon la revendication 3, dans lequel l'étape d'élimination de l'espaceur (14) est précédée ou suivie d'une étape d'implantation d'une autre zone active avec un dopant d'un autre type de conductivité que celle du dopant utilisé à l'étape d).

5. Procédé selon la revendication 1, dans lequel, entre l'étape de remplissage de la tranchée et l'étape c) de formation d'un espaceur, est prévue une étape consistant à former, à la surface de la zone active, un revêtement de protection (12).

6. Procédé selon la revendication 5, dans lequel le revêtement de protection (12) résulte de la croissance thermique d'une couche mince d'oxyde de silicium à la surface du substrat (10).

7. Procédé selon l'une quelconque des revendications 1 à 6, dans lequel l'espaceur est en nitrure de silicium.

8. Procédé selon l'une quelconque des revendications 1 à 6, dans lequel l'espaceur (14) est en silicium polycristallin.

9. Transistor MOS comportant une zone de canal effective dopée adjacente à une tranchée remplie d'un isolant (11), **caractérisé en ce que** les dopants présents dans la partie de la zone de canal à proximité de la zone isolante sont plus proches de la surface que les dopants présents dans le reste de la zone de canal.

10. Circuit intégré sur un substrat semiconducteur comprenant au moins un transistor selon la revendication 9.

11. Terminal mobile comprenant un circuit intégré selon la revendication 10.

## Claims

1. A method of forming an active channel area surrounded with an insulating area (11) in a semiconductor substrate (10), including the steps of:
a) forming in the substrate a trench surrounding an active area;
b) filling the trench with an insulating material (11) to form an edge extending beyond the surface of the substrate at the periphery of the active area;
c) forming a spacer (14) at the periphery of said edge; and
d) implanting a dopant, whereby the implantation in the area located under the spacer is less deep than in the rest of the active area.

2. The method of claim 1, wherein the spacer (14) has a substantially vertical edge or has a bell shape, with a thickness that thins down as the distance from said edge increases.

3. The method of claim 1, wherein the implantation step is followed by a step of removing the spacer (14).

4. The method of claim 3, wherein the step of removing the spacer (14) is preceded or followed by a step of implantation of another active area with a dopant of another conductivity type than that of the dopant used at step d).

5. The method of claim 1, wherein a step consisting of forming, at the surface of the active area, a protective coating (12), is provided between the trench filling step and spacer forming step c).

6. The method of claim 5, wherein the protective coating (12) results from the thermal growth of a thin silicon oxide layer at the surface of the substrate (10).

7. The method of any of claims 1 to 6, wherein the spacer is made of silicon nitride.

8. The method of any of claims 1 to 6, wherein the spacer (14) is made of polysilicon.

9. A MOS transistor including a doped effective channel area adjacent to a trench filled with an insulating material (11), wherein the dopants present in the portion of the channel area close to the insulating material are closer to the surface than the dopants present in the rest of the channel area.

10. An integrated circuit on a semiconductor substrate including at least one transistor of claim 9.

11. A mobile terminal including the integrated circuit of claim 10.

## Patentansprüche

1. Ein Verfahren zum Ausbilden eines aktiven Kanalbereichs, der von einem Isolierbereich (11) umgeben ist, und zwar in einem Halbleitersubstrat (10), wobei das Verfahren die folgenden Schritte aufweist:
a) Ausbilden in dem Substrat eines Grabens, der einen aktiven Bereich umgibt;
b) Füllen des Grabens mit einem Isoliermaterial (11) zur Ausbildung einer Kante, die sich über die Oberfläche des Substrats hinaus erstreckt, und zwar im Umfang des aktiven Bereichs;
c) Ausbilden eines Abstandshalters (14), an dem Umfang der Kante; und
d) Implantieren eines Dotiermittels, wobei die Implantierung in dem Bereich unterhalb des Abstandshalters weniger tief ist als im Rest des aktiven Bereichs.

2. Verfahren nach Anspruch 1, wobei der Abstandshalter (14) eine im wesentlichen vertikale Kante oder eine Glockenform besitzt, mit einer Dicke, die mit größer werdendem Abstand von der Kante dünner wird.

3. Verfahren nach Anspruch 1, wobei dem Implantierschritt ein Schritt des Entfernens des Abstandshalters (14) folgt.

4. Verfahren nach Anspruch 3, wobei dem Schritt des Entfernens des Abstandshalters (14) ein Schritt des Implantierens eines anderen aktiven Bereichs mit einem Dotiermittel eines anderen Leitfähigkeittyps, als dem Dotiermittel das im Schritt d) verwendet wurde, folgt.

5. Verfahren nach Anspruch 1, wobei ein Schritt des Formens einer Schutzbeschichtung (12) einer Oberfläche des aktiven Bereichs vorgesehen ist zwischen dem Grabenfüllschritt und dem Schritt c) des Ausbilden des Abstandshalters.

6. Verfahren nach Anspruch 5, wobei die Schutzschicht (12) sich aus dem thermischen Wachstum einer dünnen Siliziumoxydschicht auf der Oberfläche des Substrats (10) ergibt.

7. Verfahren nach einem der Ansprüche 1 bis 6, wobei der Abstandshalter aus Siliziumnitrid hergestellt wird.

8. Verfahren nach einem der Ansprüche 1 bis 6, wobei der Abstandshalter (14) aus Polysilizium hergestellt wird.

9. Ein MOS Transistor, einschließlich eines dotierten effektiven Kanalbereichs benachbart zu einem Graben, der mit einem Isoliermaterial (11) gefüllt ist, wobei die Dotiermittel, die in dem Teil des Kanalbereichs in der Nähe des Isoliermaterials liegen näher an der Oberfläche sind als die Dotiermittel in dem Rest des Kanalbereichs.

10. Integrierte Schaltung auf einem Halbleitersubstrat einschließlich wenigstens eines Transistors nach Anspruch 9.

11. Mobiles Terminal einschließlich der integrierten Schaltung nach Anspruch 10.
